# EUROPÄISCHE PATENTSCHRIFT

(11) **EP 2 499 673 B1**
(45) Veröffentlichungstag und Bekanntmachung des Hinweises auf die Patenterteilung: **21.02.2018**
(21) Anmeldenummer: 10759617.3
(22) Anmeldetag: 23.09.2010
(51) Int. Cl.: H01L 29/861, H01L 29/872

(54) **Schotty-Diode und Verfahren zu deren Herstellung**
Schottky diode and method of manufacturing thereof
Diode Schottky et sa méthode de manufacture

(30) Priorität: 11.11.2009 DE 102009046596
(43) Veröffentlichungstag der Anmeldung: 19.09.2012
(73) Patentinhaber: Robert Bosch GmbH, 70442 Stuttgart (DE)
(72) Erfinder: QU, Ning, 72770 Reutlingen (DE); GOERLACH, Alfred, 72127 Kusterdingen (DE)
(86) Internationale Anmeldenummer: PCT/EP2010/064003
(87) Internationale Veröffentlichungsnummer: WO 2011/057848

(56) Entgegenhaltungen:
- EP-A1- 1 496 549
- WO-A1-2006/048387
- HOSSAIN Z ET AL: "Forward drop-leakage current tradeoff analysis of a junction barrier Schottky (JBS) rectifier", POWER SEMICONDUCTOR DEVICES AND ICS, 1999. ISPSD '99. PROCEEDINGS., TH E 11TH INTERNATIONAL SYMPOSIUM ON TORONTO, ONT., CANADA 26-28 MAY 1999, PISCATAWAY, NJ, USA,IEEE, US, 26. Mai 1999 (1999-05-26), Seiten 265-268, XP010331499, DOI: DOI:10.1109/ISPSD.1999.764114 ISBN: 978-0-7803-5290-2

## Beschreibung

### Stand der Technik

Dies Erfindung betrifft eine Halbleiteranordnung einer Schottkydiode, die kleinen Leckstrom und niedrige Flussspannung aufweist, sich mit Hilfe von relativ einfacher Technologie herstellen lässt und insbesondere als Z-Leistungsdiode mit einer Durchbruchspannung von ca. 20V für den Einsatz in Kfz-Generatorsysteme eignet.

In modernen Kraftfahrzeugen werden immer mehr Funktionen mit elektrischen Bauelementen realisiert. Dadurch entsteht ein immer höherer Bedarf an elektrischer Leistung. Um diesen Bedarf zu decken, muss die Effizienz des Generatorsystems im Kfz gesteigert werden. Bis heute werden in der Regel PN-Dioden als Z-Dioden im Kfz-Generatorsystem eingesetzt. Vorteile der PN-Dioden sind einerseits der niedrige Sperrstrom und andererseits die hohe Robustheit. Der Hauptnachteil ist die hohe Flussspannung *UF*. Bei Raumtemperatur beginnt Strom erst mit *UF*=0.7V zu fließen. Unter normaler Betriebsbedingung, z. B. einer Stromdichte von 500A/cm², steigt *UF* bis über 1V an, was einen unvernachlässigbaren Verlust der Effizienz bedeutet.

Theoretisch stehen Schottkydioden als Alternative zur Verfügung. Schottkydioden haben eine deutlich niedrigere Flussspannung als PN-Dioden, beispielweise 0,5V bis 0,6V bei einer hohen Stromdichte von 500A/cm². Außerdem bieten Schottkydioden als Majoritätsträgerbauelemente Vorteile bei schnellem Schaltbetrieb. Der Einsatz von Schottkydioden in Kfz-Generatorsystemen erfolgt jedoch bis heute nicht. Dies ist auf einige entscheidende Nachteile von Schottkydioden zurückzuführen: 1) höherer Sperrstrom im Vergleich zu PN-Dioden, 2) starke Abhängigkeit des Sperrstroms von Sperrspannung, und 3) schlechte Robustheit, insbesondere bei Hochtemperatur. Es gibt daher Ideen und Konzepte, Schottkydioden zu verbessern. Im Folgenden werden zwei Beispiele ausgeführt.

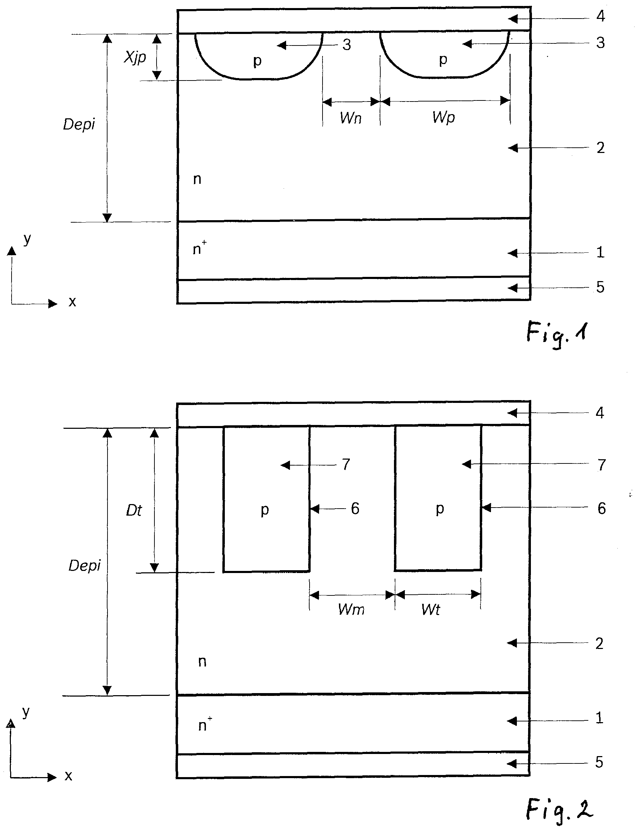

Sogenannte **J**unction-**B**arrier-**S**chottkydioden (JBS) sind bereits bekannt und werden in S.Kunori, etc., "Low leakage current Schottky barrier diode", Proceedings of 1992 International Symposium on Power Semiconductors & ICs, Tokyo, pp. 80-85 gezeigt. Wie Fig. 1 zu entnehmen ist, besteht eine JBS aus einem n⁺-Substrat **1,** einer n-Epischicht **2,** mindestens zwei in die n-Epischicht **2** diffundierten p-Wannen **3** und Metallschichten an der Vorderseite **4** und an der Rückseite **5** des Chips. Elektrisch gesehen ist die JBS eine Kombination von PN-Diode, also PN-Übergang zwischen den p-Wannen **3** als Anode und der n-Epischicht **2** als Kathode und einer Schottkydiode mit der Schottky-Barriere zwischen der Metallschicht **4** als Anode und der n-Epischicht **2** als Kathode. Die Metallschicht an der Rückseite des Chips **5** dient als Kathodenelektrode, die Metallschicht an der Vorderseite des Chips **4** als Anodenelektrode mit ohmschem Kontakt zu den p-Wannen **3** und gleichzeitig als Schottky-Kontakt zur n-Epischicht **2.**

Wegen der kleinen Flussspannung der Schottkydiode im Vergleich zur PN-Diode fließen Ströme in der Flussrichtung nur durch den Bereich der Schottkydiode. In Folge dessen ist die effektive Fläche, also die Fläche pro Flächeneinheit für den Stromfluss in Flussrichtung bei einer JBS deutlich kleiner als bei einer konventionellen Planar-Schottkydiode.

In der Sperrrichtung dehnen sich die Raumladungszonen mit steigender Spannung aus und stoßen bei einer Spannung, die kleiner als die Durchbruchspannung der JBS ist, in der Mitte des Bereichs zwischen den benachbarten p-Wannen **3** zusammen. Dadurch wird der Schottky-Effekt, bzw. Barrier-Lowering-Effekt, der für die hohen Sperrströme verantwortlich ist, teilweise abgeschirmt und der Sperrstrom reduziert. Dieser Abschirmeffekt ist stark von den Strukturparametern *Xjp* (Eindringtiefe der p-Diffusion), *Wn* (Abstand zwischen den p-Wannen) sowie *Wp* (Breite der p-Wanne) und von Dotierkonzentrationen der p-Wanne **3** und der n-Epischicht **2** abhängig, siehe Fig. 1.

Stand der Technik zur Realisierung der p-Wannen **3** einer JBS ist die p-Implantation und anschließende p-Diffusion. Durch laterale Diffusion in der x-Richtung, deren Tiefe vergleichbar mit der vertikalen Diffusion in der y-Richtung ist, entstehen zylindrische p-Wannen in der zweidimensionalen Darstellung d.h. unendliche Länge in der z-Richtung senkrecht zur x-y-Ebene, deren Radius der Eindringtiefe *Xjp* entspricht. Wegen der radialen Ausdehnung der Raumladungszonen zeigt diese Form von p-Wannen keine sehr wirkungsvolle Abschirmung des Barrier-Lowering-Effektes. Es ist nicht möglich, allein durch tiefere p-Diffusion die Abschirmwirkung zu verstärken, da gleichzeitig auch die laterale Diffusion entsprechend breiter wird. Den Abstand zwischen den p-Wannen *Wn* zu verkleinern ist auch keine gute Lösung, da dadurch zwar die Abschirmwirkung verstärkt, die effektive Fläche für den Stromfluss in Flussrichtung wird aber weiter reduziert wird.

Eine Alternative zur Verbesserung der Abschirmwirkung des Barrier-Lowering-Effekts einer JBS ist die aus der DE 10 2004 053 761 A bekannte sogenannte **T**rench-**J**unction-**B**arrier-**S**chottkydiode TJBS mit ausgefüllten Gräben. Fig. 2 zeigt eine solche TJBS. Sie besteht aus einem n⁺-Substrat **1,** einer n-Epischicht **2,** mindestens zwei in die n-Epischicht **2** eingeätzten Gräben bzw. Trenches **6** und Metallschichten an der Vorderseite des Chips **4** als Anodenelektrode und an der Rückseite des Chips **5** als Kathodenelektrode. Die Gräben werden mit p-dotiertem Si oder Poly-Si **7** ausgefüllt. Insbesondere kann die Metallschicht **4** auch aus mehreren unterschiedlichen, übereinander liegenden Metallschichten bestehen. Der Übersichtlichkeit ist dies in Fig. 2 nicht eingezeichnet.

Elektrisch gesehen ist die TJBS eine Kombination von PN-Diode mit einem PN-Übergang zwischen den p-dotierten Gräben **7** als Anode und der n-Epischicht **2** als Kathode und einer Schottkydiode mit der Schottky-Barriere zwischen der Metallschicht **4** als Anode und der n-Epischicht **2** als Kathode. Wie bei einer konventionellen JBS fließen Ströme in der Flussrichtung nur durch die Schottkydiode. Wegen fehlender lateraler p-Diffusion ist jedoch die effektive Fläche für Stromfluss in der Flussrichtung bei der TJBS deutlich größer als bei konventioneller JBS. In der Sperrrichtung dehnen sich die Raumladungszonen mit steigender Spannung aus und stoßen sich bei einer Spannung, die kleiner als die Durchbruchspannung der TJBS ist, in der Mitte des Bereichs zwischen den benachbarten Gräben **6** zusammen. Wie bei der JBS wird dadurch der für hohe Sperrströme verantwortliche Barrier-Lowering-Effekt abgeschirmt und die Sperrströme reduziert. Dieser Abschirmeffekt ist stark von Strukturparametern *Dt* (Tiefe des Grabens), *Wm* (Abstand zwischen den Gräben) sowie *Wt* (Breite des Grabens) und von Dotierkonzentrationen der p-Wanne **7** und der n-Epischicht **2** abhängig, siehe Fig. 2.

Zur Realisierung der Gräben bei der TJBS wird auf die p-Diffusion verzichtet. Dadurch gibt es keine negative Auswirkung von lateraler p-Diffusion wie bei konventioneller JBS. Eine quasi-eindimensionale Ausdehnung der Raumladungszonen in dem Mesa-Bereich zwischen den Gräben **6** kann ohne weiteres realisiert werden, da die Tiefe des Grabens *Dt,* ein wichtiger Strukturparameter für die Abschirmung des Schottky-Effektes, nicht mehr mit der effektiven Fläche für Stromfluss in der Flussrichtung korreliert. Die Abschirmwirkung von Schottky-Effekten ist damit deutlich effektiver als bei der JBS mit diffundierten p-Wannen.

Andererseits bietet die TJBS eine hohe Robustheit durch seine Klammerfunktion. Die Durchbruchspannung der PN-Diode *BV_pn* wird so ausgelegt, dass *BV_pn* niedriger als die Durchbruchspannung der Schottkydiode *BV_schottky* ist und der Durchbruch am Boden der Gräben stattfindet. Im Durchbruchsbetrieb fließt der Sperrstrom dann nur durch den PN-Übergang. Flussrichtung und Sperrrichtung sind damit geometrisch getrennt. Die TJBS verfügt damit über eine ähnliche Robustheit wie eine PN-Diode. In Folge dessen ist die TJBS als Z-Diode für den Einsatz in Kfz-Generatorsystem gut geeignet.

EP1496549 beschreibt eine Schottky-Diode.

### Offenbarung der Erfindung

### Vorteile der Erfindung

Der Vorteil der Erfindung besteht darin, eine Halbleiteranordnung einer Schottkydiode mit kleinem Leckstrom, niedriger Flussspannung und hoher Robustheit zu schaffen, die sich mit Hilfe von relativ einfachen Technologien herstellen lässt und die als Z-Leistungsdiode für Einsatz in Kfz-Generatorsystemen geeignet ist. Erzielt werden diese Vorteile durch eine Halbleiteranordnung einer Schottkydiode mit den Merkmalen des Anspruchs 1.

In besonders vorteilhafter Weise ist die Schottkydiode dieser Erfindung eine Kombination von PN-Diode mit einer niedrigen Durchbruchspannung und Schottkydiode mit einer viel höheren Durchbruchspannung. Dies wird realisiert durch unterschiedliche Dotierprofile, die die unterschiedlichen Durchbruchspannungen der PN-Diode und der Schottkydiode bestimmen. Dadurch wird die elektrische Feldstärke am Schottky-Kontakt so stark reduziert, sodass eine aufwändige sub-µ Trench-Technologie zur effektiven Unterdrückung des Barrier-Lowering-Effekts, wie bei TJBS oder TMBS, nicht mehr erforderlich ist.

Im Vergleich zur JBS wird in vorteilhafter Weise ein deutlich kleinerer Leckstrom durch deutlich niedrigere elektrische Feldstärke am Schottky-Kontakt erhalten. Im Vergleich zur TJBS fließt ein vergleichbarer Leckstrom und es ist vergleichbare Robustheit erhältlich mit dem besonderen Vorteil einer deutlich einfacheren Herstellungstechnologie.

### Kurze Beschreibung der Zeichnungen

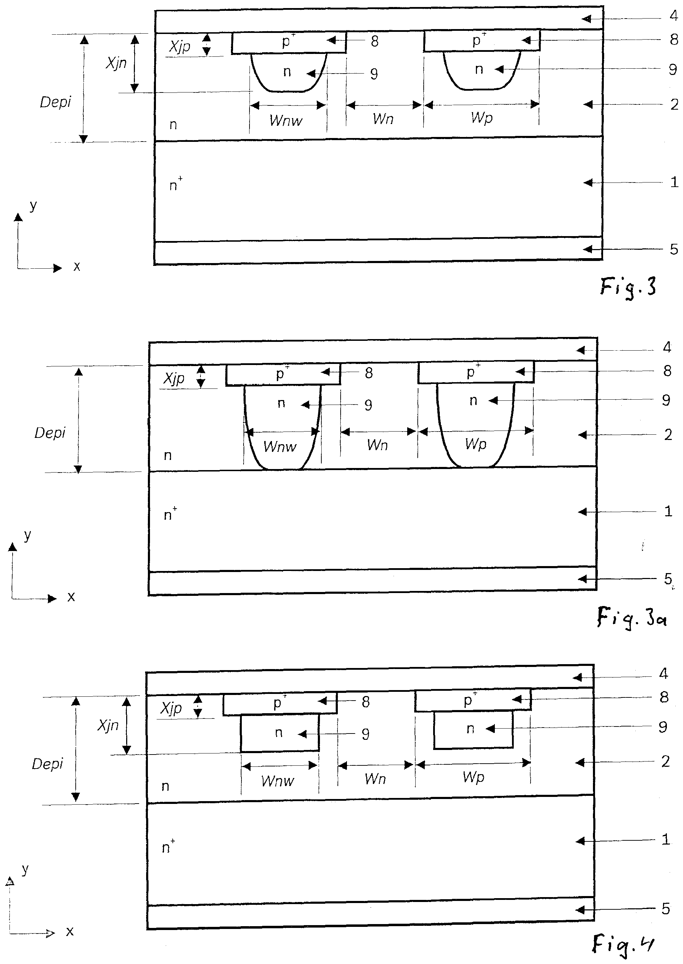

Figur 1 zeigt eine Junction-Barrier-Schottkydiode (JBS), Figur 2 eine Trench-Junktion-Barrier-Schottkydiode (TJBS) mit ausgefülltem Graben. In Figur 3 ist ein erstes Ausführungsbeispiel einer erfindungsgemäßen Halbleiteranordnung einer Schottkydiode dargestellt und in Figur 3a eine Ausgestaltung des ersten Ausführungsbeispiels. Weitere drei Ausführungsbeispiele von erfindungsgemäßen Schottkydioden sind in den Figuren 4, 5 und 6 dargestellt.

### Ausführungsformen der Erfindung

Üblicherweise ist es bei konventioneller JBS nach Figur 1 oder TJBS nach Figur 2 die selbe n-Epischicht, die als Kathodenzone der Schottkydiode und die Kathodenzone der integrierten PN-Diode dient. Die Durchbruchspannung der Schottkydiode *BV_schottky* ist i. a. nicht viel höher als die Durchbruchspannung der integrierten PN-Diode *BV_pn.* Daher tritt beim Durchbruch der PN-Diode auch am Schottky-Kontakt eine hohe elektrische Feldstärke und als Folge der Barrier-Lowering-Effekt auf, der zum hohen Leckstrom führt. Zur Unterdrückung des Barrier-Lowering-Effekts, bzw. zur Reduzierung des Leckstroms wird bei JBS, bzw. TJBS ein Zusammenstoßen der Raumladungszone zwischen den P-dodierten Bereichen ausgenutzt. Dies ist wegen des zweidimensionalen Effekts der diffundierten PN-Übergänge bei JBS nicht besonders ausgeprägt. TJBS erfordert andererseits einen hohen Technologieaufwand zur Realisierung der feinen Trench-Strukturen.

Der Barrier-Lowering-Effekt nimmt mit zunehmender Sperrspannung zu. Je höher die elektrische Feldstärke am Schottkykontakt ist, desto geringer ist die Schottkybarriere. Falls die elektrische Feldstärke am Schottky-Kontakt relativ niedrig gehalten werden kann, z.B. etwa 1E5V/cm, dann ist die Auswirkung der Spannungsabhängigkeit des Barrier-Lowering-Effekts vernachlässigbar. Dies lässt sich realisieren, wenn eine Schottkydiode mit integrierter PN-Diode so ausgelegt wird, dass die Durchbruchspannung der Schottkydiode *BV_schottky* sehr viel höher als die Durchbruchspannung der integrierten PN-Diode *BV_pn* gewählt wird. Mit Erhöhung der Durchbruchsspannung *BV_schottky* einer Schottkydiode, steigt andererseits aber auch der Spannungsabfall bei Betrieb in Durchlassrichtung. Aus diesem Grund vermeidet man hohe Durchbruchsspannungen *BV_schottky* und legt die Schottkydiode so aus, dass *BV_schottky* nur wenig höher als *BV_pn* ist. Mit der in der Erfindung vorgeschlagenen Maßnahme, können die

Schottkydioden zur Sperrstromreduzierung für wesentlich höhere Durchbruchsspannungen ausgelegt werden, ohne dass die Flussspannung stark ansteigt.

Das erste Ausführungsbeispiel dieser Erfindung ist in Figur 3 bzw. 3a dargestellt. Diese Halbleiteranordnung einer Schottkydioden-Variante besteht aus einem n⁺-Substrat **1,** einer n-Epischicht **2,** den in die n-Epischicht **2** diffundierten n-Wannen **9** mit einer Breite *Wnw* und einer Tiefe *Xjn,* den in die n-Epischicht **2** und in die n-Wannen **9** diffundierten p⁺-Wannen **8** mit einer Breite *Wp* und einer Tiefe *Xjp* und einem Abstand zwischen den benachbarten p⁺-Wannen **8** *Wn,* die sich zusammen mit den n-Wannen **9** PN-Übergänge bilden, und Metallschichten an der Vorderseite des Chips **4** als Anodenelektrode und an der Rückseite des Chips **5** als Kathodenelektrode. Die Tiefe der n-Wannen **9** *Xjn* ist größer als die Tiefe der p⁺-Wannen **8** *Xjp* und die Breite der n-Wannen **9** *Wnw* ist kleiner als die Breite der p⁺-Wannen **8** *Wp.* Wie in Abb. 3a dargestellt, die Tiefe der n-Wannen **9** kann sich u. U. auch bis zum n⁺-Substrat **1** oder sogar darüber hinaus erstrecken.

Diese Schottkydioden-Variante ist eine Kombination von einer Schottkydiode mit einer Schottky-Barriere zwischen der Metallschicht 4 als Anode und der n-Epischicht 2 als Kathode und einer PN-Diode mit einemn PN-Übergang zwischen der p⁺-Wanne 8 als Anode und der n-Wanne 9 als Kathode.

Im Unterschied zu der in Figur 1 dargestellten JBS ist die integrierte PN-Diode der Schottkydiode dieser Erfindung nicht mehr mit Hilfe von relativ tiefer in die n-Epischicht diffundierten p-Wannen realisiert. Die integrierte PN-Diode besteht nun aus den in die n-Epischicht 2 diffundierten n-Wannen 9 und den relativ flacher p⁺-Wannen 8. Die Schottkydiode bildet sich wie bei der konventionellen JBS aus dem Schottky-Kontakt und der n-Epischicht; die Dotierkonzentration der n-Epischicht **2** ist jedoch sie viel niedriger als die Dotierkonzentration der n-Wanne **9.** Die Dotierprofilen der n-Wannen **9** und der p⁺-Wannen **8** werden so eingestellt, dass die Durchbruchspannung der PN-Diode *BV_pn* ca. 20V beträgt. Zudem wird die n-Epischicht **2** ausreichend dick ausgelegt, damit die Durchbruchspannung der Schottkydiode *BV_schottky* viel höher als *BV_pn* ist, z.B. *BV_pn* = 20V und *BV_schottky* > 60V.

Dadurch ist die elektrische Feldstärke am Schottky-Kontakt beim Durchbruch der Schottkydiode dieser Erfindung signifikant kleiner als die elektrische Feldstärke am PN-Übergang, z.B. ca. 1E5V/cm anstatt 5E5V/cm. Daher befindet sich die hier beschriebene Schottkydiode auch im Durchbruchszustand nicht in dem Bereich, in dem der spannungsabhängige Barrier-Lowering-Effekt eine Rolle spielt. Das ist ein völlig anderes Konzept als bei der konventionellen JBS oder der in Figur 2 dargestellten TJBS, den Barrier-Lowering-Effekt durch Zusammenstoßen der Raumladungszone zu unterdrücken und dadurch den Leckstrom zu reduzieren. Im Vergleich zur konventionellen JBS ist die Reduzierung des Leckstroms bei der Schottkydiode dieser Erfindung viel effektiver, da der spannungsabhängige Barrier-Lowering-Effekt gar nicht vorkommt. Und im Vergleich zur in Figur 2 dargestellten TJBS ist der Technologieaufwand bei der Schottkydiode dieser Erfindung viel kleiner, da sub-µ Trench-Technologie zur Realisierung von feinen Trench-Strukturen für eine effektive Unterdrückung des Barrier-Lowering-Effekts nicht erforderlich ist.

Bei der Halbleiteranordnung einer Schottkydiode dieser Erfindung fließen Ströme in der Flussrichtung, wie bei konventioneller JBS oder TJBS, nur durch die Schottkydiode, falls die Flussspannung der Schottkydiode deutlich kleiner als Flussspannung der PN-Diode ist. Die n-Wannen **9** dienen aber zusätzlich dazu, die Flussspannung zu reduzieren, da der Flussstrom teils durch die höher dotierten n-Wannen **9** fließen wird. Der Bahnwiderstand der Schottkydiode wird durch die n-Wannen **9** in vorteilhafter Weise reduziert.

Die Schottkydiode dieser Erfindung bietet hohe Robustheit durch die Klammerfunktion wie eine in Figur 2 dargestellte TJBS, da der Durchbruch ebenfalls am tief im Silizium liegenden PN-Übergang stattfindet und im Durchbruchsbetrieb Sperrströme nur durch den PN-Übergang fließen. Die Schottkydiode dieser Erfindung verfügt damit über ähnliche Robustheit wie eine PN-Diode. Dabei ist es zu bemerken, dass die PN-Diode der Schottkydiode dieser Erfindung aus einem weitgehend eindimensionalen PN-Übergang besteht, da die Breite der n-Wannen **9** *Wnw* kleiner als die Breite der p⁺-Wannen **8** *Wp* ist, und dies zu einer homogenen Stromverteilung beim Durchbruch und zu einer hohen Robustheit führt.

Bei Auslegung der Schottkydiode dieser Erfindung können zahlreiche Parameter je nach Applikationen hinsichtlich Flussspannung, Leckstrom und Robustheit optimiert werden. Dabei spielt insbesondere die Dotierkonzentration und die Dicke der n-Epischicht **2** eine entscheidende Rolle. Bei Bedarf kann ein graduiertes Profil der n-Epischicht **2** von Vorteil sein.

Figur 4 zeigt das zweite Ausführungsbeispiel dieser Erfindung. Der Unterschied zu der in Figur 3 dargestellten Schottkydiode-Variante ist, dass die n-Wannen **9** nun durch Trench-Technik realisiert werden. So ist die Auswirkung der Reduzierung der Flussspannung mit Hilfe von n-Wannen **9** noch effektiver.

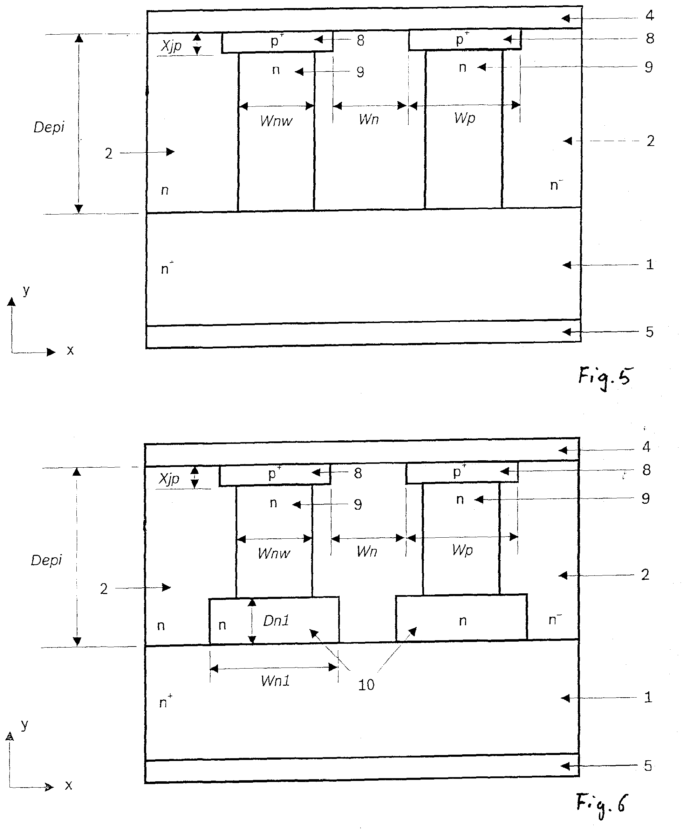

Figur 5 zeigt das dritte Ausführungsbeispiel dieser Erfindung. Der Unterschied zu der in Figur 4 dargestellten Schottkydiode-Variante ist, dass die n-Wannen **9** nun bis zum n⁺-Substrat **1** reicht, oder sogar etwas in das Substrat **1** hineinreicht. Mit dieser Variante ist eine noch weitere Reduzierung der Flussspannung bzw. Optimierung bzgl. Flussspannung, Leckstrom und Robustheit möglich.

Figur 6 zeigt das vierte Ausführungsbeispiel dieser Erfindung. Der Unterschied zu der in Figur 5 dargestellten Schottkydiode-Variante ist, dass sich zusätzliche n-Wannen **10** am Boden der n-Wannen **9** befinden. Diese zusätzlichen n-Wannen **10** haben deutlich höhere Dotierkonzentration als die n-Wannen **9** und lassen sich z.B. mit Hilfe von Buried-Layer-Technik realisieren. Diese Variante bietet mehr Spielraum zur Optimierung bzgl. Flussspannung, Leckstrom und Robustheit durch Modifizierung der Dotierkonzentration, der Breite *Wn1* und der Dicke *Dn1* der zusätzlichen n-Wannen **10.**

Mögliche Ausgestaltungen der erfindungsgemäßen Halbleiteranordnung sind:
Die Metallisierung der Metallschicht (4) und /oder der Metallschicht (5) kann aus zwei oder mehreren übereinander liegenden Metalllagen bestehen.

Die n-Wannen (9) können in Streifenanordnung oder als Inseln angeordnet sein und die Inseln kreisförmig oder sechseckig oder vorgebbar beliebig gestaltet sein.

Der Schottky-Kontakt ist beispielsweise aus Nickel, bzw. Nickelsilizid gebildet. Üblicherweise ist das Halbleitermaterial Silizium, es ist aber auch möglich, dass an Stelle von Silizium ein anderes Halbleitermaterial verwendet wird, insbesondere ein Widebandgap-Halbleitermaterial. Beispielsweise ist dabei das Widebandgap-Halbleitermaterial Siliziumkarbid SiC oder ein auf Nitriden basierendes Halbleitermaterial.

Bei den möglichen Schottkydioden-Varianten dieser Erfindung können im Randbereich des Chips auch noch zusätzliche Strukturen zur Reduktion der Randfeldstärke vorhanden sein. Dies können z. B. niedrig dotierte p-Bereiche, Feldplatten oder ähnliche dem Stand der Technik entsprechende Strukturen sein.

Mögliche Herstellungsverfahren von Schottkydiode-Varainten dieser Erfindung laufen wie folgt ab:
Variante 1 (für eine Schottkydiode nach Figur 3)
   Schritt 1: n⁺-Substrat dient als Ausgangsmaterial **1** für die Halbleiteranordnung.
   Schritt 2: mittels n-Epitaxie wird die n-Epischicht **2** erzeugt.
   Schritt 3: Eindiffundieren der n-Wannen **9** in die n-Epischicht **2.**
   Schritt 4: Mittels Diffusion werden p⁺-Wannen **8** gebildet.
   Schritt 5: Erzeugung von Metallschichten **4, 5** mittels Metallisierung auf der Vorder- und Rückseite des Chips.
Varianten 2 und 3 (für Schottkydioden nach den Figuren 4 bzw. 5)
   Schritt 1: n⁺-Substrat dient als Ausgangsmaterial **1** für die Halbleiteranordnung.
   Schritt 2: mittels n-Epitaxie wird die n-Epischicht **2** erzeugt.
   Schritt 3: Grabenätzen (bis zu n⁺-Substrat bei Variante 3)
   Schritt 4: Ausfüllen der Gräben mit n-dotiertem Si oder Poly-Si **9**
   Schritt 5: Mittels Diffusion werden p⁺-Wannen **8** gebildet.
   Schritt 6: Erzeugung von Metallschichten **4, 5** mittels Metallisierung auf der Vorder- und Rückseite des Chips.
Variante 4 (für eine Schottkydiode nach Figur 6)
   Schritt 1: n⁺-Substrat dient als Ausgangsmaterial **1** für die Halbleiteranordnung.
   Schritt 2: mittels n-Epitaxie wird die n-Epischicht **2** erzeugt.
   Schritt 3: Implantation bzw. Diffusion von n-Wannen **10.**
   Schritt 4: 2. n-Epitaxie zur Erzeugung der n-Epischicht **2.**
   Schritt 5: Grabenätzen bis zu den n-Wannen **10.**
   Schritt 6: Ausfüllen der Gräben mit n-dotiertem Si oder Poly-Si **9.**
   Schritt 7: Diffusion der p⁺-Wannen **8.**
   Schritt 8: Erzeugung von Metallschichten **4, 5** mittels Metallisierung auf der Vorder- und Rückseite des Chips.

Diese Schritte können gegebenenfalls noch durch weitere Herstellungsschritte ergänzt werden.

## Patentansprüche

1. Halbleiteranordnung einer Schottky-Diode mit integrierter PN-Diode als Klammerelement, mit einer Durchbruchspannung von ca. 20V, wobei die Schottky-Diode aus einer Kombination von Schottky-Diode und PN-Diode besteht und die Durchbruchspannung der PN-Diode *BV_pn* sehr viel niedriger als die Durchbruchspannung der Schottky-Diode *BV_schottky* ist, wobei auf einem n⁺-Substrat (1) eines Chips eine n-Epischicht (2) aufgebracht ist und als Kathodenzone der Schottky-Diode dient, **dadurch gekennzeichnet, dass** sich die Halbleiteranordnung als Z_Diode zum Einsatz in Kfz-Generatorsystem eignet, dass in der n-Epischicht (2) als ausgefüllter Gräben realisierte n-Wannen (9) vorhanden sind und als Kathodenzone der PN-Diode dienen, und entsprechende in die n-Epischicht (2) und in die n-Wannen (9) diffundierten p⁺-Wannen (8) vorhanden sind und als Anodenzone der PN-Diode dienen und dass die n-Wannen (9) in Streifenanordnung oder als Inseln angeordnet sind und die Inseln kreisförmig oder sechseckig oder vorgebbar beliebig gestaltet sind und wobei die Gräben eine rechteckige Form, eine U- oder eine sonstige vorgebbar beliebige Form aufweisen.

2. Halbleiteranordnung nach Anspruch 1, **dadurch gekennzeichnet, dass** die n-Wannen (9) bis zum n⁺-Substrat (1) reichen.

3. Halbleiteranordnung nach einem der vorhergehenden Ansprüche, **dadurch gekennzeichnet, dass** sich zusätzliche n-Wannen (10) mit höherer Dotierkonzentration im Vergleich zu den n-Wannen (9) zwischen den n-Wannen (9) und dem n⁺-Substrat (1) befinden.

4. Halbleiteranordnung nach Anspruch 1 oder 3, **dadurch gekennzeichnet, dass** sie mit hohen Strömen im Durchbruch betrieben werden kann.

5. Halbleiteranordnung nach einem der vorhergehenden Ansprüchen, **dadurch gekennzeichnet, dass** sich eine Metallschicht (5) an der Rückseite des Chips befindet und als Kathodenelektrode dient, und eine Metallschicht (4) an der Vorderseite des Chips befindet, mit ohmschem Kontakt zu den p⁺-Wannen (8) und mit Schottky-Kontakt zur n-Epischicht (2) und als Anodenelektrode dient.

6. Halbleiteranordnung nach Anspruch 1, 2, 3 oder 5, **dadurch gekennzeichnet, dass** der Durchbruch der PN-Diode am Übergang zwischen den p⁺-Wannen (8) und den n-Wannen (9) stattfindet.

7. Halbleiteranordnung nach einem der vorhergehenden Ansprüchen, **dadurch gekennzeichnet, dass** zur Realisierung einer viel höheren Durchbruchspannung der Schottky-Diode *BV_schottky* im Vergleich zur Durchbruchspannung der integrierten PN-Diode *BV_pn* die Dotierkonzentration der n-Epischicht (2) viel niedriger als die Dotierkonzentration der n-Wannen (9) und die n-Epischicht (2) ausreichende Dicke hat.

8. Halbleiteranordnung nach einem der vorhergehenden Ansprüchen, **dadurch gekennzeichnet, dass** die Breite der n-Wannen (9) *Wnw* kleiner als die Breite der p⁺-Wannen (8) *Wp* ist und dadurch der Durchbruch an einem weitgehend eindimensionalen PN-Übergang stattfindet.

9. Halbleiteranordnung nach einem der vorhergehenden Ansprüchen, **dadurch gekennzeichnet, dass** die Metallisierung der Metallschicht (4) und /oder der Metallschicht (5) aus zwei oder mehreren übereinander liegenden Metalllagen besteht.

10. Halbleiteranordnung nach einem der vorhergehenden Ansprüchen, bei dem der Schottky-Kontakt aus Nickel, bzw. Nickelsilizid gebildet wird.

11. Halbleiteranordnung nach einem der vorhergehenden Ansprüchen **dadurch gekennzeichnet, dass** an Stelle von Silizium ein anderes Halbleitermaterial verwendet wird, insbesondere ein Widebandgap-Halbleitermaterial.

12. Halbleiteranordnung nach Anspruch 12, **dadurch gekennzeichnet, dass** das Halbleitermaterial, insbesondere Widebandgap-Halbleitermaterial SiC ist oder ein auf Nitriden basierendes Halbleitermaterial.

13. Halbleiteranordnung nach einem der vorhergehenden Ansprüchen **dadurch gekennzeichnet, dass** im Randbereich des Chips zusätzliche Strukturen zur Reduktion der Randfeldstärke ausgebildet sind.

14. Halbleiteranordnung nach Anspruch 13, **dadurch gekennzeichnet, dass** die zusätzliche Strukturen niedrig dotierte p-Bereiche und/oder Feldplatten und/oder ähnliche Strukturen sind.

15. Verfahren zur Herstellung einer Halbleiteranordnung nach Anspruch 2, **dadurch gekennzeichnet, dass** wenigstens die folgenden Schritte durchgeführt werden:
Schritt 1: n⁺-Substrat dient als Ausgangsmaterial **1** für die Halbleiteranordnung.
Schritt 2: mittels n-Epitaxie wird die n-Epischicht **2** erzeugt.
Schritt 3: Grabenätzen (bis zu n⁺-Substrat bei Variante 3)
Schritt 4: Ausfüllen der Gräben mit n-dotiertem Si oder Poly-Si **9** Schritt 5: Mittels Diffusion werden p⁺-Wannen **8** gebildet.
Schritt 6: Erzeugung von Metallschichten **4, 5** mittels Metallisierung auf der Vorder- und Rückseite des Chips.

16. Verfahren zur Herstellung einer Halbleiteranordnung nach Anspruch 3, **dadurch gekennzeichnet, dass** wenigstens die folgenden Schritte durchgeführt werden:
Schritt 1: n⁺-Substrat dient als Ausgangsmaterial **1** für die Halbleiteranordnung.
Schritt 2: mittels n-Epitaxie wird die n-Epischicht **2** erzeugt.
Schritt 3: Implantation bzw. Diffusion von n-Wannen **10.**
Schritt 4: 2. n-Epitaxie zur Erzeugung der n-Epischicht **2.**
Schritt 5: Grabenätzen bis zu den n-Wannen **10.**
Schritt 6: Ausfüllen der Gräben mit n-dotiertem Si oder Poly-Si **9.**
Schritt 7: Diffusion der p⁺-Wannen **8.**
Schritt 8: Erzeugung von Metallschichten **4, 5** mittels Metallisierung auf der Vorder- und Rückseite des Chips.

## Claims

1. Semiconductor arrangement of a Schottky diode with an integrated PN diode as a clamping element, having a breakdown voltage of approximately 20V, wherein the Schottky diode consists of a combination of Schottky diode and PN diode and the breakdown voltage of the PN diode *BV_pn* is very much lower than the breakdown voltage of the Schottky diode *BV_Schottky,* wherein an n-type epitaxial layer (2) is applied on an n⁺-type substrate (1) of a chip and serves as a cathode zone of the Schottky diode, **characterized in that** the semiconductor arrangement is suitable as a Zener diode for use in a motor vehicle generator system, **in that** n-type wells (9) realized as filled trenches are present in the n-type epitaxial layer (2) and serve as a cathode zone of the PN diode, and corresponding p⁺-type wells (8) diffused into the n-type epitaxial layer (2) and into the n-type wells (9) are present and serve as an anode zone of the PN diode, and **in that** the n-type wells (9) are arranged in a strip arrangement or as islands and the islands are configured in circular fashion or hexagonal fashion or predefinably arbitrary fashion and wherein the trenches have a rectangular shape, a U-shape or some other predefinably arbitrary shape.

2. Semiconductor arrangement according to Claim 1, **characterized in that** the n-type wells (9) extend as far as the n⁺-type substrate (1).

3. Semiconductor arrangement according to either of the preceding claims, **characterized in that** additional n-type wells (10) having a higher doping concentration in comparison with the n-type wells (9) are situated between the n-type wells (9) and the n⁺-type substrate (1).

4. Semiconductor arrangement according to Claim 1 or 3, **characterized in that** it can be operated with high currents at breakdown.

5. Semiconductor arrangement according to any of the preceding claims, **characterized in that** a metal layer (5) is situated at the rear side of the chip and serves as a cathode electrode, and a metal layer (4) is situated at the front side of the chip, with ohmic contact with the p⁺-type wells (8) and with Schottky contact with the n-type epitaxial layer (2), and serves as an anode electrode.

6. Semiconductor arrangement according to Claim 1, 2, 3 or 5, **characterized in that** the breakdown of the PN diode takes place at the junction between the p⁺-type wells (8) and the n-type wells (9).

7. Semiconductor arrangement according to any of the preceding claims, **characterized in that** in order to realize a much higher breakdown voltage of the Schottky diode *BV*_*schottky* in comparison with the breakdown voltage of the integrated PN diode *BV_pn,* the doping concentration of the n-type epitaxial layer (2) is much lower than the doping concentration of the n-type wells (9) and the n-type epitaxial layer (2) has a sufficient thickness.

8. Semiconductor arrangement according to any of the preceding claims, **characterized in that** the width of the n-type wells (9) *Wnw* is less than the width of the p⁺-type wells (8) *Wp* and as a result the breakdown takes place at a largely one-dimensional PN junction.

9. Semiconductor arrangement according to any of the preceding claims, **characterized in that** the metallization of the metal layer (4) and/or of the metal layer (5) consists of two or more metal plies lying one above another.

10. Semiconductor arrangement according to any of the preceding claims, wherein the Schottky contact is formed from nickel or from nickel silicide.

11. Semiconductor arrangement according to any of the preceding claims, **characterized in that** a different semiconductor material, in particular a wide-bandgap semiconductor material, is used instead of silicon.

12. Semiconductor arrangement according to Claim 12, **characterized in that** the semiconductor material, in particular the wide-bandgap semiconductor material is SIC or a semiconductor material based on nitrides.

13. Semiconductor arrangement according to any of the preceding claims, **characterized in that** additional structures for reducing the marginal field strength are formed in the marginal region of the chip.

14. Semiconductor arrangement according to Claim 13, **characterized in that** the additional structures are lightly doped p-type regions and/or field plates and/or similar structures.

15. Method for producing a semiconductor arrangement according to Claim 2, **characterized in that** at least the following steps are carried out:
step 1: n⁺-type substrate serves as starting material 1 for the semiconductor arrangement.
step 2: the n-type epitaxial layer **2** is produced by means of n-type epitaxy.
step 3: trench etching (as far as n⁺-type substrate in variant 3).
step 4: filling the trenches with n-doped Si or poly-Si **9.**
step 5: p⁺-type wells **8** are formed by means of diffusion.
step 6: producing metal layers **4, 5** by means of metallization on the front and rear sides of the chip.

16. Method for producing a semiconductor arrangement according to Claim 3, **characterized in that** at least the following steps are carried out:
step 1: n⁺-type substrate serves as starting material **1** for the semiconductor arrangement.
step 2: the n-type epitaxial layer **2** is produced by means of n-type epitaxy.
step 3: implantation or diffusion of n-type wells **10.**
step 4: 2^{nd} n-type epitaxy for producing the n-type epitaxial layer **2.**
step 5: trench etching as far as the n-type wells **10.**
step 6: filling the trenches with n-doped Si or poly-Si **9.**
step 7: diffusion of the p⁺-type wells **8.**
step 8: producing metal layers **4, 5** by means of metallization on the front and rear sides of the chip.

## Revendications

1. Ensemble semi-conducteur d'une diode Schottky à diode PN intégrée en tant qu'élément de blocage, présentant une tension de claquage d'environ 20 V, dans lequel la diode Schottky est constituée d'une combinaison d'une diode Schottky et d'une diode PN et la tension de claquage *BV_pn* de la diode PN est très inférieure à la tension de claquage *BV_schottky* de la diode Schottky, dans lequel une couche épitaxiale de type n (2) est formée sur un substrat de type n⁺ (1) d'une puce et est utilisée en tant que zone de cathode de la diode Schottky, **caractérisé en ce que** l'ensemble semi-conducteur se prête à une utilisation en tant que diode Zenner dans des systèmes d'alternateurs de véhicules automobiles, **en ce que** des puits de type n (9) réalisés dans la couche épitaxiale de type n (2) sous la forme de tranchées remplies sont présents et sont utilisés en tant que zone de cathode de la diode PN, et **en ce que** des puits de type p⁺ (8) correspondants dans la couche épitaxiale de type n (2) et diffusés dans les puits de type n (9) sont présents et sont utilisés en tant que zone d'anode de la diode PN et les puits de type n (9) sont agencés selon un agencement en bandes ou sous forme d'îlots et **en ce que** les îlots sont configurés de manière circulaire ou hexagonale ou de manière quelconque et pouvant être prédéterminée et dans lequel les tranchées présentent une forme rectangulaire, une forme en U ou une forme quelconque de ce type pouvant être prédéterminée.

2. Ensemble semi-conducteur selon la revendication 1, **caractérisé en ce que** les puits de type n (9) s'étendent jusqu'au substrat de type n⁺ (1).

3. Ensemble semi-conducteur selon l'une des revendications précédentes, **caractérisé en ce que** des puits de type n (10) supplémentaires ayant une concentration en dopant plus élevée par comparaison aux puits de type n (9) se trouvent entre les puits de type n (9) et le substrat de type n⁺ (1).

4. Ensemble semi-conducteur selon la revendication 1 ou 3, **caractérisé en ce qu'**il peut être attaqué avec des courants de claquage plus élevés.

5. Ensemble semi-conducteur selon l'une des revendications précédentes, **caractérisé en ce qu'**une couche métallique (5) se trouve sur la face arrière de la puce et est utilisée en tant qu'électrode de cathode et une couche métallique (4) se trouve sur la face avant de la puce, en contact ohmique avec les puits de type p⁺ (8) et en contact de Schottky avec la couche épitaxiale de type n (2) et est utilisée en tant qu'électrode d'anode.

6. Ensemble semi-conducteur selon la revendication 1, 2, 3 ou 5, **caractérisé en ce que** le claquage de la diode PN se produit à la transition entre les puits de type p⁺ (8) et les puits de type n (9).

7. Ensemble semi-conducteur selon l'une des revendications précédentes, **caractérisé en ce que**, pour obtenir une tension de claquage *BV_schottky* très supérieure de la diode Schottky par comparaison à la tension de claquage *BV_pn* de la diode PN intégrée, la concentration en dopant de la couche épitaxiale de type n (2) est très inférieure à la concentration en dopant des puits de type n (9) et la couche épitaxiale de type n (2) présente une épaisseur suffisante.

8. Ensemble semi-conducteur selon l'une des revendications précédentes, **caractérisé en ce que** la largeur *Wnw* des puits de type n (9) est inférieure à la largeur *Wp* des puits de type p⁺ (8), de sorte que le claquage se produit au niveau d'une transition PN essentiellement unidimensionnelle.

9. Ensemble semi-conducteur selon l'une des revendications précédentes, **caractérisé en ce que** la métallisation de la couche métallique (4) et/ou de la couche métallique (5) est constituée de deux alliages métalliques disposés l'un sur l'autre, ou plus.

10. Ensemble semi-conducteur selon l'une des revendications précédentes, dans lequel le contact Schottky est réalisé à partir de nickel ou de siliciure de nickel.

11. Ensemble semi-conducteur selon l'une des revendications précédentes, **caractérisé en ce qu'**en certains points du silicium, un autre matériau semi-conducteur est utilisé, en particulier un matériau semi-conducteur à large bande interdite.

12. Ensemble semi-conducteur selon la revendication 11, **caractérisé en ce que** le matériau semi-conducteur, en particulier le matériau semi-conducteur à large bande interdite, est le SiC ou un matériau semi-conducteur à base de nitrures.

13. Ensemble semi-conducteur selon l'une des revendications précédentes, **caractérisé en ce que** des structures supplémentaires destinées à réduire les intensités de champ périphériques sont réalisées dans la zone périphérique de la puce.

14. Ensemble semi-conducteur selon la revendication 13, **caractérisé en ce que** les structures supplémentaires sont des régions de type p faiblement dopées et/ou des plaques de champ et/ou des structures de ce type.

15. Procédé de fabrication d'un ensemble semi-conducteur selon la revendication 2, **caractérisé en ce qu'**au moins les étapes suivantes sont effectuées :
Etape 1 : un substrat de type n⁺ est utilisé en tant que matériau de départ 1 pour l'ensemble semi-conducteur.
Etape 2 : la couche épitaxiale de type n (2) est générée par épitaxie de type n.
Etape 3 : gravure de tranchées (jusqu'au substrat de type n⁺ selon une variante 3).
Etape 4 : remplissage des tranchées par du Si dopé ou
du polySi de type n 9.
Etape 5 : des puits de type p⁺ (8) sont formés par diffusion.
Etape 6 : des couches métalliques 4, 5 sont produites par métallisation sur les faces avant et arrière de la puce.

16. Procédé de fabrication d'un ensemble semi-conducteur selon la revendication 3, **caractérisé en ce qu'**au moins les étapes suivantes sont effectuées :
Etape 1 : un substrat de type n⁺ est utilisé en tant que matériau de départ 1 pour l'ensemble semi-conducteur.
Etape 2 : la couche épitaxiale de type n (2) est produite par épitaxie de type n.
Etape 3 : implantation ou diffusion de puits de type n (10).
Etape 4 : deuxième épitaxie de type n pour produire la couche épitaxiale de type n 2.
Etape 5 : gravure de tranchées jusqu'aux puits de type n 10.
Etape 6 : remplissage des tranchées par du Si ou du poly-Si dopé de type n 9.
Etape 7 : diffusion des puits de type p⁺ 8.
Etape 8 : production de couches métalliques 4, 5 par métallisation sur les faces avant et arrière de la puce.
